Europäisches Patentamt

European Patent Office

Office européen des brevets

(11) Veröffentlichungsnummer: **0 005 461**
**B1**

(12) **EUROPÄISCHE PATENTSCHRIFT**

(45) Veröffentlichungstag der Patentschrift: **21.10.81**

(21) Anmeldenummer: **79101240.4**

(22) Anmeldetag: **24.04.79**

(51) Int. Cl.³: **H 01 L 29/80**

(54) **Metall-Halbleiter-Feldeffekttransistor(MESFET)und Verfahren zu dessen Herstellung.**

(30) Priorität: **19.05.78 DE 2821975**

(43) Veröffentlichungstag der Anmeldung:
**28.11.79 Patentblatt 79/24**

(45) Bekanntmachung des Hinweises auf die Patenterteilung:
**21.10.81 Patentblatt 81/42**

(84) Benannte Vertragsstaaten:
**BE FR GB IT NL**

(56) Entgegenhaltungen:
**DE - A - 2 321 895**
**DE - A - 2 444 489**

(73) Patentinhaber: **SIEMENS AKTIENGESELLSCHAFT**
**Berlin und München**
**Postfach 22 02 61**
**D-8000 München 22 (DE)**

(72) Erfinder: **Ristow, Dietrich, Dr.**
**Pappelstrasse 35**
**D-8014 Neubiberg (DE)**

Metall-Halbleiter-Feldeffekttransistor (MESFET) und Verfahren zu dessen Herstellung

Der Erfindung bezieht sich auf einen Metall-Halbleiter-Feldeffekttransistor (MESFET) wie er im Oberbegriff des Patentanspruches 1 angegeben ist, sowie auf ein Verfahren zu dessen Herstellung. Ein derartiger Metall-Halbleiter-Feldeffekttransistor ist aus der DE - A - 2 321 895 bekannt.

Aus dem Stand der Technik sind Feldeffekttransistoren bekannt, bei denen die Gate-Elektrode zwischen dem Source-Gebiet und dem Drain-Gebiet unmittelbar auf der Halbleiteroberfläche aufliegt und einen Metall-Halbleiter (Schottky-) Kontakt bildet. Solche Feldeffekttransistoren werden als MESFETs bezeichnet. Ein solcher MESFET wird z.B. auf einer auf einem isolierenden Substrat befindlichen Halbleiterschicht aufgebaut, wobei die Schichtdicke üblicherweise 0,1 bis 0,5 $\mu$m beträgt und die Dotierung dieses Halbleitermaterials in der Größenordnung von $10^{17}$ Teilchen pro cm liegt. Die Kontaktgebiete für Source und Drain haben üblicherweise einen Abstand von etwa 3 bis 7 $\mu$m voneinander und zwischen diesen beiden Gebieten liegt ein streifenförmiger Schottky-Kontakt mit einer Breite von 0,5 bis 2 $\mu$m. Als Halbleitermaterial kommt für MESFETs vorzugsweise Galliumarsenid in Frage.

Für Leitstungs-MESFET s kommt es unter anderem darauf an, daß die parasitären Widerstände an den Kontakten und in der Halbleiterschicht kleingehalten sind und an das Drain-Gebiet eine gegenüber dem Source-Gebiet große elektrische Spannung angelegt werden kann, ohne daß es in der Halbleiterschicht zwischen diesen Gebieten zum elektrischen Durchbruch kommt.

Bisher wurde dieses Problem in der Weise gelöst, daß man eine relativ dicke Halbleiterschicht vorgesehen hat und den Kontaktstreifen für das Gate in einem etwas vertieften Bereich der Halbleiterschicht angebracht hat. Damit wurde erreicht, daß unter dem als Gate dienenden Kontaktstreifen die Halbleiterschicht diejenige geringe Dicke hat, die für die Funktion eines MESFET's erforderlich ist. Die dagegen dickeren Schichtanteile außerhalb des Gate-Gebietes tragen zu einer Verminderung der parasitären Widerstände bei. Es ist auch bereits vorgesehen worden, sowohl das Source-Gebiet als auch das Drain-Gebiet mit einer erhöhten Dotierung von z.B. $10^{18}$ Teilchen pro cm³ zu versehen. Damit wurde nicht nur der Kontaktwiderstand zwischen dem Material der Halbleiterschicht und der darauf befindlichen Kontaktmetallisierung mit ohm'schen Übergang verringert und der Bahnwiderstand in der Halbleiterschicht verkleinert, sondern es konnten auch höhere elektrische Spannungen angelegt werden. Außerdem ließ sich damit auch die Rauscheigenschaft verbessern. Zu diesem Stand der Technik sei unter anderem auf die Druckschriften IEEE MT-24, 1976, 312-317, Proc. 6. Intern. Symposium über Galliumarsenid and Related Compounds, St. Louis (1976), S. 262-270 und IEEE ED-24 (1977) 1129-1130 hingewiesen.

Nach IEEE ISSCC Digest of Technical Papers (1978) 118-119 lassen sich gute Leistungs-MESFET's auch dann erzielen, wenn die Dotierung im Source-Gebiet und im Drain-Gebiet bei nur etwa $10^{17}$ Teilchen pro cm³ liegt und die Dicke der Halbleiterschicht entsprechend groß gewählt wird.

Es ist eine Aufgabe der vorliegenden Erfindung, einen MESFET, insbesondere der letztgenannten Art für seine Funktion als Leistungs-MESFET zu optimieren.

Diese Aufgabe wird bei einem MESFET nach dem Oberbegriff des Patentanspruches 1 erfindungsgemäß gelöst, wie dies im Kennzeichen des Anspruches 1 angegeben ist. Ein besonders bevorzugtes Herstellungsverfahren für einen erfindungsgemäßen MESFET gibt Patentanspruch 5 an.

Die Erfindung geht von der Überlegung aus, daß die größten elektrischen Feldstärken, die zu einem Durchbruch führen können, beim MESFET zwischen dem Gate- und dem Drain-Gebiet auftreten. Deshalb ist es von Vorteil, in diesem Bereich eine geringere Dotierungskonzentration vorzusehen. Es wurde festgestellt daß der sich damit ergebende elektrische Widerstand zwischen Gate- und Drain-Gebiet auf der Verstärkungswirkung einen relativ geringen Einfluß hat, vergleichsweise geringer als ein Widerstand zwischen dem Gate- und dem Source-Gebiet. Aus diesem Grunde ist auch für das Source-Gebiet gemäß einem Merkmal der Erfindung eine entartete ($N^+-$)Dotierung von Vorteil. Erfindungsgemäß ist somit für die drei Gebiete des Drain, des Gate und des Source, die Abstände voneinander haben, die bei einigen $\mu$m liegen, die Dotierungsbedingung $N_D < N_G < N_S$ zu erfüllen.

Weitere Erläuterungen zur Erfindung gehen aus der nachfolgenden Beschreibung eines erfindungsgemäßen MESFET's und eines bevorzugten Verfahrens zur Herstellung eines solchen Feldeffekttransistors hervor.

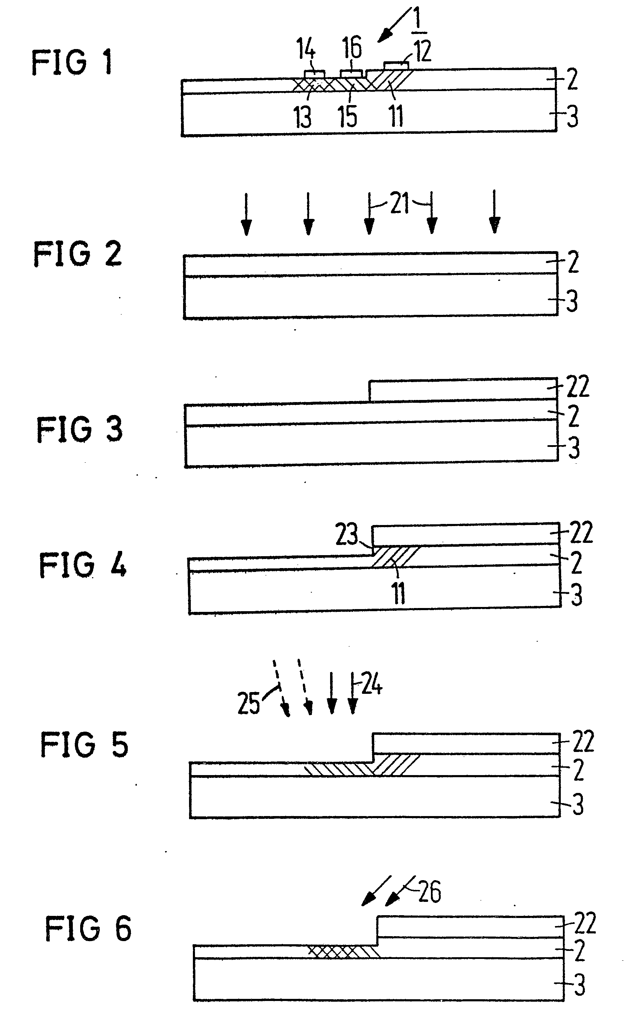

Figur 1 zeigt einen erfingungsgemäßen MESFET und die Figuren 2 bis 6 ziegen einzelne Verfahrensschritte eines Herstellungsverfahrens.

Mit 1 ist ein in einer Halbleiterschicht 2 befindlicher, erfindungsgemäßer MES-Feldeffekttransistor bezeichnet. Die Halbleiterschicht 2 aus vorzugsweise Galliumarsenid befindet sich auf einem insbesondere elektrisch isolierenden Substratkörper 3. Dieser kann insbesondere hochohmiges oder semiisolierend gemachtes (kompensiertes) Galliumarsenid sein.

Durch Schraffur ist ein mit 11 bezeichnetes Drain-Gebiet kenntlich gemacht, auf dem ein mit 12 bezeichneter Metallkontakt zur Stromzuführung vorgesehen ist. Ein solcher Kontakt
12 ist im Regelfall ein Anteil einer als Zuleitung
dienenden Leiterbahn, z.B. aus einer Goldlegierung. Mit einer weiteren Schraffur 13 ist ein als
Source-Gebiet wirksamer Bereich der Halbleiterschicht 2 kenntlich gemacht, auf dem ein
14 entsprechender Kontakt für dieses Gebiet
angebracht ist. Mit 16 ist ein bereits oben
erwähnter Metallstreifen bezeichnet, der einen
Gate- (Schottky-)Metall-Halbleiterkontakt auf
der Halbleiterschicht 2 bildet. Aufgrund, wie an
sich bekannt, gegenüber den an den Source-
und Drain-Gebieten anliegenden, vergleichsweise zum Potential des Streifens 16 unterschiedlichen Potentialen bildet sich unterhalb
dieses Metallstreifens 16 ein elektrisch steuernd
wirkender Gate-Beriech 15 aus, der wiederum
durch eine Schraffur kenntlich gemacht ist.

Erfindungsgemäß ist in dem MESFET 1 z.B.
für Galliumarsenid eine Dotierungsverteilung
vorgesehen, bei der die Dotierung im Drain-
Gebiet 11 weniger als $10^{17}$ Teilchen pro cm$^3$
beträgt. In dem Gate-Bereich 15 ist eine Dotierung von beispielsweise 1 bis 4. $10^{17}$ Teilchen
pro cm$^3$ vorgesehen. Im Source-Gebiet 13
dagegen ist eine Dotierung von 1 bis 8. $10^{18}$
Teilchen pro cm$^3$ vorhanden. Für eine untere
Grenze der Dotierung des Drain-Gebietes 11 ist
zu beachten, daß noch ausreichende elektrische Leitfähigkeit vorhanden ist, damit kein
unzulässig großer parasitärer Widerstand entsteht. Für die obere Grenze der Dotierung des
Source-Gebietes 13 ist zu beachten, daß die
Dotierung nicht derart groß sein darf, daß
Kristallgitterdefekte die beabsichtigte Dotierung
kompensieren oder zumindest beeinträchtigen.
Vorzugsweise ist z.B. für Galliumarsenid N-
Dotierung für die Gebiete bzw. Bereiche vorgesehen.

Außerhalb der Gebiete 11, 13 und 15 ist im
Regelfall eine niedrige Dotierung von $10^{15}$
Teilchen pro cm$^3$ oder weniger vorzusehen. Eine
Dotierung kann dort aber auch vollständig
weggelassen sein oder die Schicht weggeätzt
sein.

Die Herstellung eines wie erfindungsgemäßen MESFET's erfolgt vorzugsweise nach
dem nachfolgend beschriebenen erfindungsgemäß vorzunehmenden technologischen Verfahren.

Figure 2 zeigt den bereits erwähnten Substratkörper 3, auf dem sich die Halbleiterschicht 2 aus z.B. Galliumarsenid oder Silizium
oder Indiumphosphid befindet. Zunächst wird in
einem ersten Verfahrensschritt diese Halbleiterschicht 2 z.B. im Herstellungsverfahren der
Schicht 2 oder durch nachfolgende Eindiffusion
oder auch durch ganzflächige Ionenimplantation soweit dotiert, daß die für das Drain-
Gebiet 11 vorhandene Dotierung von nicht
mehr als $10^{17}$ Teilchen pro cm$^3$ vorliegt.

Mit den Pfeilen 21 ist ein beispielsweise
Ionenimplantationsverfahren zur Herstellung der

Dotierung dieses Verfahrensschrittes angedeutet.

Figur 3 zeigt den Substratkörper 3 mit der
darauf befindlichen Halbleiterschicht 2, auf der
sich eine Beschichtung oder Maske 22 befindet,
die einen Anteil der Oberfläche der Halbleiterschicht 2 abdeckt. Insbesondere wird damit der
Bereich der Halbleiterschicht 2 abgedeckt, in
dem sich das Drain-Gebiet 11 befindet. Diese
Abdeckung 22 kann mit Hilfe eines aufgedampften Metalls oder aber auch mittels eines
Fotolacks hergestellt werden.

Figure 4 ziegt das Ergebnis eines weiteren
Verfahrensschrittes, mit Hilfe dessen eine oberflächliche Abtragung der Halbleiterschicht 2
erreicht worden ist. Die Dicke der Abtragung
beträgt z.B. 20 nm. Sie führt zu einer mit 23
bezeichneten Stufe, die für einen späteren Verfahrensschritt dazu dient, die Grenze des schraffiert angedeuteten späteren Drain-Gebietes 11
wiederzuerkennen.

Figure 5 ziegt wiederum das Substrat 3 mit
der darauf befindlichen Halbleiterschicht 2, auf
der sich immer noch die Abdeckung 22 befindet. In einem nächsten Verfahrensschritt wird
jetzt die Halbleiterschicht 2 in dem durch die
Abdeckung 22 nicht abgedeckten Bereich
weiter dotiert bis zur Höhe der vorgesehenen
Dotierung des Gate-Gebietes mit 1 bis 4 . $10^{17}$
Teilchen pro cm$^3$. Diese Dotierung kann z.B.
wiederum mit Hilfe einer Implantation vorgenommen werden. Für diese Implantation ist
darauf zu achten, daß kein wesentlicher Abschattungseffekt durch die Abdeckung 22
erfolgt. Die Implantationsrichtung kann wie
durch die Pfeile 24 und 25 angedeutet (und mit
dazwischenliegenden Richtungen) durchgeführt werden.

In einem weiteren Implantationsschritt wird
mit einer, wie durch die Pfeile 26 angedeutet,
ausgerichteten Implantation, die noch höhre
Dotierung des Source-Gebietes mit 1 bis
8 . $10^{18}$ Teilchen pro cm$^3$ vorgenommen. Für
diese den Pfeilen 26 entsprechende Implantationsrichtung ist zu beachten, daß sie abhängig
von der Dicke der abschattenden Kante der Abdeckung 22 derart ist, daß der Abschattungseffekt bewirkt, daß von der Stufe 23 (in der
Figur 6 nach links) gesehen, ein nicht weiter dotierter Zwischenraum verbleibt, nämlich für den
Gate-Bereich 15 des Transistors nach Figur 1.

In weiteren nicht weiter dargestellten Verfahrensschritten wird dann die Abdeckung 22
entfernt und es werden die Kontakte 12, 14 und
16 angebracht.

Bei Ausführung des erfindungsgemäßen Herstellungsverfahrens mit Implantation in allen
Verfahrensschritten braucht lediglich zwischen
den einzelnen Verfahrensschritten nur die
Implantationsrichtung, z.B. durch Winkelschwenkung des Substratkörpers auf seinem
Träger verändert zu werden. Die Dotierungssubstanz kann jeweils dieselbe bleiben.

Das Herstellungsverfahren eines erfingundsgemäßen MESFET's kann gemäß einer Variation des voranstehend beschriebenen Herstellungsverfahrens auch so verändert werden, daß die Dotierungsschritte der Figuren 2, 5 und 6 in ihrer Reihenfolge miteinander vertauscht werden. Zum Beispiel kann erst die Implantation 26 des Source-Gebietes (Figure 6) vorgenommen werden und dann nachfolgend die Implantation gemäß Figur 5 vorgenommen werden. Gemäß einer anderen Variation kann z.B. die der Figur 2 entsprechende Implantation 21 nach dem Verfahrensschritt der Figur 6 vorgenommen werden, und zwar nach Entfernung der Abdeckung 22. Es ist lediglich darauf zu achten, daß jeweils in den einzelnen Gebieten bzw. Bereichen die erfindungsgemäß abgestufte Dotierung im Ergebnis vorliegt.

Gemäß einer weiteren Ausgestaltung des erfingungsgemäßen MESFET's bzw. des erfingungsgemäßen Herstellungsverfahrens kann vorgesehen sein, daß vor, nach oder während des Verfahrensschrittes der Figur 2 eine nur oberflächliche, d.h. in der Halbleiterschicht 2 mit nur geringer Eindringtiefe vorliegende Implantation vorgenommen wird, die zu einer (oberflächlichen) hohen Dotierung in der Größenordnung von 1 bis $8 . 10^{18}$ Teilchen pro $cm^3$ führt. Eine solche oberflächliche Zusatzdotierung führt zu einer Verringerung des Kontaktwiderstandes zwischen dem Metallkontakt 12 und dem ansonsten nur niedrig dotierten Drain-Gebiet 11. Die Eindringtiefe dieser erhöhten Dotierung ist insbesondere so gewählt, daß sie nicht über das Maß der Abstufung 23 hinausgeht, so daß durch den Verfahrensschritt der Figur 4 außerhalb des Drain-Gebietes diese erhöhte Oberflächendotierung, d.h. dieses hochdotierte Halbleitermaterial der Oberflächenschicht der Halbleiterschicht 2 bereits wieder entfernt ist. Ein Rest der hochdotierten Oberflächenschicht kann auch unmittelbar vor dem Aufbringen des Metallstreifens 16 abgetragen werden.

### Patentansprüche

1. Metall - Halbleiter - Feldeffekttransistor (MESFET) mit hochdotiertem Source-, Drain- und Gate-Gebiet, wobei das Gate-Gebiet weniger hoch als das Source-Gebiet dotiert ist, gekennzeichnet dadurch, daß die Dotierung des Drain-Gebietes (11) weniger hoch als die des Gate-Gebietes (15) ist.

2. Metall-Halbleiter-Feldeffekttransistor nach Anspruch 1, gekennzeichnet dadurch, daß das material des Halbleiters Galliumarsenid ist.

3. Metall-Halbleiter-Feldeffekttransistor nach Anspruch 1 oder 2, gekennzeichnet dadurch, daß das Halbleitermaterial eine auf einem Substratkörper (3) befindliche dünne Schicht (2) ist.

4. Metall-Halbleiter-Feldeffekttransistor nach einem der Ansprüche 1 bis 3, gekennzeichnet dadurch, daß N-Dotierung vorhanden ist.

5. Verfahren zur Herstellung eines Metall-Halbleiter-Feldeffekttransistors nach einem der Ansprüche 1 bis 4, gekennzeichnet durch die Verfahrensschritte: Aufbringen einer einen fur das Drain-Gebiet vorgesehenen Anteil der Oberfläche des Halbleitermaterials (2) abdeckenden Abdeckung (22), Abtragen eines dickenmäßigen Anteils des Halbleitermaterials (2) außerhalb des abgedeckten (22) Oberflächenanteils, Implantationsdotierung des Halbleitermaterials (2) zum einen aus einer Richtung (Fig. 5), bei der kein Abschattungseffekt an der vom Rand der Abdeckung (22) gebildeten Kante erfolgt und zum anderen aus einer Richtung, bei der an dieser Kante der Abdeckung (22) eine Abschattung für die Dotierung des Halbleitermaterials (2) vorliegt (Figuren 5 und 6), daß die Abdeckung (22) wieder entfernt wird und daß vor dem Aufbringen der Abdeckung oder nach dem Entfernen der Abdeckung (22) eine ganzflächige Dotierung des Halbleitermaterials (2) erfolgt, wobei die Dotierung im abgedeckten (22) Bereich geringer als die ohne Abschattung vorgenommene Dotierung ist und die ohne Abschattung vorgenommene Dotierung geringer als die mit Abschattungseffekt erfolgte Dotierung ist.

6. Verfahren nach Anspruch 5, gekennzeichnet dadurch, daß die Dotierung ohne Abschattung (Fig. 5) vor der Dotierung mit Abschattung (Fig. 6) erfolgt.

7. Verfahren nach Anspruch 5 oder 6, gekennzeichnet dadurch, daß vor der Aufbringung einer Abdeckung (22) (Fig. 3) eine nur die Oberflächen mit geringer Eindringtiefe und mit hohem Dotierungsgrad bemessene Dotierung erfolgt.

8. Verfahren nach Anspruch 5 oder 6, gekennzeichnet dadurch, daß nachdem die Abdeckung (22) wieder entfernt ist eine nur die Oberflächen mit geringer Eindringtiefe und mit hohem Dotierungsgrad bemessene Dotierung erfolgt.

### Claims

1. Metal-semiconductor field effect transistor (MESFET) having highly-doped source, drain and gate zones, wherein the gate zone is not so highly doped as the source zone, characterised in that the doping of the drain zone (11) is not as high as that of the gate zone (15).

2. Metal-semiconductor field effect transistor according to Claim 1, characterised in that the material of the semiconductor is gallium arsenide.

3. Metal-semiconductor field effect transistor according to Claim 1 or Claim 2, characterised in that the semiconductor material is a thin layer (2) arranged on a substrate body (3).

4. Metal-semiconductor field effect transistor as claimed in one of the Claims 1 to 3, characterised in that N-doping is present.

5. Process for the production of a metal-semiconductor field effect transistor as claimed in one of the Claims 1 to 4, characterised by the process steps: application of a covering (22) which covers a part of the surface of the semi-conductor material (2) provided for the drain zone, removal of a portion thicknesswise of the semi-conductor material (2) outside the covered (22) part of the surface, implantation doping of the semiconductor material (2), on the one hand, from a direction (Fig. 5) iun which no shading effect occurs at the border formed by the edge of the covering (22) and, on the other hand, from a direction in which a shading effect as regards the doping of the semiconductor material (2) occurs at this border of the covering (22) (Figures 5 and 6), that the covering (22) is removed and that prior to the application of the covering, or after the removal of the covering (22), a whole-surface doping of the semi-conductor material (2) takes place, the doping in the covered (22) region being lower than the doping carried out without shading, and the doping carried out without shading being lower than the doping which took place with a shading effect.

6. Process as claimed in Claim 5, characterised in that the doping without shading (Fig. 5) takes place before the doping with shading (Fig. 6).

7. Process as claimed in Claim 5 or 6, characterised in that prior to the application of a covering (22) (Fig. 3) a doping which has a low penetration depth and a high doping level takes place only at the surfaces.

8. Process as claimed in Claim 5 or 6, characterised in that after the removal of the covering (22) a doping which has a low penetration depth and a high doping level takes place only at the surfaces.

**Revendications**

1. Transistor à effet de champ métal-semi-conducteur (MESFET) comportant une région de source, une région de drain et une région de grille fortement dopées et dans lequel la région de grille est moins fortement dopée que la région de source, caractérisé par le fait que le dopage de la région de drain (11) est moins élevé que celui de la région de grille (15).

2. Transistor à effet de champ métal-semiconducteur selon la revendication 1, caractérisé par le fait que le matériau du semiconducteur est de l'arseniure de gallium.

3. Transistor à effet de champ métal-semiconducteur selon la revendication 1 ou 2, caractérisé par le fait que le matériau semiconducteur est une couche mince (2) située sur un corps formant substrat (3).

4. Transistor à effet de champ métal-semiconducteur selon l'une des revendications 1 à 3, caractérisé par le fait que le dopage est du type N.

5. Procédé pour fabriquer un transistor á effet de champ métal-semiconducteur selon l'une des revendications 1 à 4, caractérisé par les phases opératoires: dépôt d'un revêtement (22) recouvrant une partie, prévue pour la région de drain, de la surface du matériau semiconducteur (2), enlèvement d'une partie d'une certaine épaisseur du matériau semiconducteur (2) en dehors de l'élément de surface recouvert (22), dopage par implantation du matériau semiconducteur (2) d'une part suivant une direction (figure 5), suivant laquelle il ne se produit aucun effet de masquage au niveau de l'arête formée par le bord du revêtement (22), et d'autre part suivant une direction, dans laquelle il se présente, au niveau de ce bord du revêtement (22) un masquage pour le dopage du matériau semiconducteur (2) (figures 5 et 6), enlèvement du revêtement (22) et, avant le dépôt du revêtement ou après l'élimination du revêtement (22), mise en oeuvre d'un dopage sur toute la surface du matériau semiconducteur (2), ledit dopage étant plus faible dans la zone recouverte (22) que le dopage réalisé sans masquage, et le dopage réalisé sans masquage étant plus faible que le dopage réalisé avec effet de masquage.

6. Procédé selon la revendication 5, caractérisé par le fait que le dopage sans masquage (figure 5) est réalisé avant le dopage avec masquage (figure 6).

7. Procédé selon la revendication 5 ou 6, caractérisé par le fait qu'avant le dépôt d'un revêtement (22) (figure 3), on réalise un dopage uniquement superficiel, avec une faible profondeur de pénétration et un degré élevé de dopage.

8. Procédé selon la revendication 5 ou 6, caractérisé par le fait qu'après avoir enlevé à nouveau le revêtement (22), on réalise un dopage seulement superficiel avec une faible profondeur de pénétration et un degré élevé de dopage.

**FIG 1**

14  16  1
12

13  15  11

2
3

**FIG 2**

21

2
3

**FIG 3**

22
2
3

**FIG 4**

23
22
2
11
3

**FIG 5**

25  24

22
2
3

**FIG 6**

26

22
2
3

1